(19) Europäisches Patentamt
European Patent Office
Office européen des brevets

(11) Numéro de publication: **0 045 678**
**B1**

(12) **FASCICULE DE BREVET EUROPEEN**

(45) Date de publication du fascicule du brevet: **23.01.85**

(51) Int. Cl.⁴: **H 01 L 33/00**, H 01 S 3/19

(21) Numéro de dépôt: **81401160.7**

(22) Date de dépôt: **21.07.81**

(54) **Source laser à jonction semiconductrice utilisant des diodes Schottky, et procédé de fabrication.**

(30) Priorité: **31.07.80 FR 8016947**

(43) Date de publication de la demande: **10.02.82 Bulletin 82/6**

(45) Mention de la délivrance du brevet: ***23.01.85 Bulletin 85/4***

(84) Etats contractants désignés: **DE GB NL**

(56) Documents cités:
**FR - A - 2 445 638**
**US - A - 4 048 627**
**US - A - 4 149 175**
**US - A - 4 182 995**
**US - A - 4 206 468**

**Collected Papers of MBE-CST-2, 1982, Tokyo, pp. 89-92**
**Applied Physics Letters 38 (01-06-81), pp 845-847**
**Prospectus CIT-ALCATEL, resultat de mesures de contact**

(73) Titulaire: **Bouley, Jean-Claude, 35, Avenue du Docteur Durand, F-94110 Arcueil (FR)**
Titulaire: **Charil, Josette, 61, Avenue Victor Hugo, F-92140 Clamart (FR)**
Titulaire: **Chaminant, Guy, 64 bis rue de Paris, F-91570 Bievres (FR)**

(72) Inventeur: **Bouley, Jean-Claude, 35, Avenue du Docteur Durand, F-94110 Arcueil (FR)**
Inventeur: **Charil, Josette, 61, Avenue Victor Hugo, F-92140 Clamart (FR)**
Inventeur: **Chaminant, Guy, 64 bis rue de Paris, F-91570 Bievres (FR)**

(74) Mandataire: **Mongrédien, André et al, c/o BREVATOME 25, rue de Ponthieu, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**EP 0 045 678 B1**

BUNDESDRUCKEREI BERLIN

## Description

La présente invention a pour objet une source lumineuse à jonction semiconductrice, du type laser, et un procédé de fabrication d'une telle source. Elle trouve une application en optique et plus spécialement en télécommunications optiques. De manière plus précise, la description qui va suivre concerne les lasers du type à double hétérostructure et à jonction en forme de ruban car ces lasers constituent des sources privilégiées dans les télécommunications optiques utilisant le proche infrarouge.

On sait qu'un laser à double hétérostructure et à jonction comprend un substrat sur lequel sont déposées successivement une couche inférieure de confinement, une couche active, une couche supérieure de confinement et enfin une couche de contact.

Afin d'obtenir un fonctionnement continu à température ambiante, on réalise un confinement de l'injection des porteurs de charge dans une surface rectangulaire active de quelques microns de large (10 à 20 µm) (ruban), limitée aux deux extrémités par deux clivages.

Le domaine privilégié de tels lasers est celui des télécommunications par fibres optiques à longue distance, pour lesquelles les longueurs d'ondes d'émission les plus intéressantes sont situées à 1,3 et 1,55 µm.

Un laser utilisant comme matériau Ga In As P/In P et fonctionnant en continu à température ambiante est décrit dans l'article publié par J. J. HSIEH dans la revue »Applied Physics Letters«, vol. 28 p. 709 1976. Il s'agit d'un laser à ruban obtenu par bombardement protonique et émettant à 1,1 µm. Un laser émettant à 1,3 µm est décrit dans l'article de K. Oe et al, publié dans la revue »Japon J. App Phys.« vol. 16 (1977) N° 7 p. 1273. Dans ce cas, le ruban est réalisé à l'aide d'un contact ohmique déposé dans la partie dégagée d'un contact ohmique déposé dans la partie dégagée d'un diélectrique ($SiO_2$), recouvrant la plaque. Un article intitulé »Ga In As P/In P planar stripe lasers prepared by using sputtered $SiO_2$ film as a Zn-diffusion mask« publié par K. Oe et al dans la revue »J. Appl Phys« 51 (1) janvier 1980 p. 43, décrit l'influence de la technologie utilisée pour réaliser le ruban (dépôt de $SiO_2$ et diffusion de zinc) sur les propriétés des lasers obtenus.

L'article de R. J. Nelson et al, intitulé »High-output power In Ga As P ($\lambda = 1{,}3$ µm) strip-buried hétérostructure lasers« et publié dans la revue »Appl. Phys Lett« 36 (5) 1 mars 1980, p. 358, décrit un laser à ruban »enterré« utilisant le composé In P.

La technique de définition du ruban la plus utilisée est celle de la prise d'un contact à travers une fenêtre, définie dans une couche de diélectrique recouvrant la couche de contact. Ce dépôt peut éventuellement servir de masque de diffusion comme il est décrit dans l'article de K. Oe cité plus haut. Cet article montre également l'influence néfaste des contraintes exercées par le diélectrique sur les mécanismes de diffusion du zinc sous le ruban et leurs conséquences sur la structure de mode du laser. Par ailleurs, ces contraintes augmentent la vitesse de dégradation des jonctions.

Les techniques d'isolation du ruban par bombardement protonique n'ont pas encore été mises en œuvre de façon satisfaisante pour des lasers émettant à 1,3 µm, sans doute en raison d'une isolation insuffisante des régions bombardées.

Quant aux lasers à structure enterrée, leur technologie semble trop compliquée (à cause notamment de la reprise d'épitaxie) pour qu'on puisse obtenir une reproductibilité et une fiabilité satisfaisantes.

Le but de l'invention est de remédier à ces inconvénients en proposant une source lumineuse à jonction semiconductrice conforme aux revendications ci-après, de structure très simple et ne faisant pas intervenir les procédés de bombardement protonique ou de dépôt de couches diélectriques.

Selon l'invention, le confinement de l'injection des porteurs de charge est obtenu grâce à la réalisation de zones présentant une diode Schottky polarisée en inverse, cette barrière s'opposant à l'injection de courant et limitant celle-ci aux zones présentant un contact ohmique ordinaire. On rappelle qu'une diode Schottky (ou diode à barrière de Schottky) est constituée d'un contact métal semi-conducteur, ce contact présentant des propriétés de redressement. Les semiconducteurs aptes à constituer de telles diodes sont connus. On pourra se reporter par exemple à l'article de W. E. SPICER et al intitulé »New and unified model for Schottky barrier and III-V insulator interface states formation« publié dans la revue J. Vac. Sci. Technol. 16(5), sept/oct. 1979.

De façon précise, l'invention a donc pour objet une source lumineuse à jonction semiconductrice telle que décrite dans la revendication 1 ci-après.

La description qui suit se réfère à des dessins annexés sur lesquels:

— la fig. 1 représente une coupe d'un laser à hétérostructure et à ruban conforme à l'invention,

— la fig. 2 représente le schéma électrique équivalent du laser de la figure précédente.

La laser représenté sur la fig. 1 comprend successivement:

- un substrat 10, par exemple en IN P, revêtu à sa partie inférieure d'un contact métallique 42 relié à la masse;
- une couche inférieure de confinement 12, par exemple en In P, dopée à l'étain (dopage n),
- une couche active 14, par exemple de composition $Ga_xIn_{1-x}As_yP_{1-y}$, où x et y sont des nombres inférieurs à 1, cette couche n'étant pas dopée, les nombres x et y étant choisis d'une part pour que le paramètre cristallin de cette couche soit en accord avec celui des couches environnantes et d'autre part pour que la longueur d'onde du rayonnement émis soit située dans la plage souhaitée (1,3 ou 1,55 $\mu m$),

- une couche supérieure de confinement 16, par exemple en In P, faiblement dopée p à l'aide de zinc (dopage de l'ordre de $10^{16}$ $cm^{-3}$),
- une couche de contact 18, par exemple de composition $Ga_xIn_{1-x}As$ (x=0,53) fortement dopée $p^+$ à l'aide de zinc, cette couche est en forme de mésa obtenu par attaque chimique sélective, et de largeur d'environ 20 $\mu m$ ou moins,
- un contact ohmique 20 en métal allié, par exemple or-zinc, ce contact recouvrant le mésa,
- une couche métallique 22, par exemple de titane recouverte d'une couche métallique 24 par exemple d'or, ces deux couches recouvrant le contact allié et la partie de la couche supérieure de confinement située de part et d'autre du mésa,
- enfin, une connexion électrique 26, reliée à une source de courant 28.

La couche métallique 22 forme, selon l'invention, avec la couche semiconductrice 16 qu'elle recouvre, une diode Schottky qui, dans les conditions normales de fonctionnement, se trouve polarisée en inverse. Le schéma électrique équivalent de l'ensemble est alors celui de la fig. 2 où l'on distingue une diode 30 qui est la partie émettrice du dispositif et qui est alimentée par la source 28 à travers une résistance 32, représentant le contact ohmique formé par la couche métallique alliée 20 et la couche de contact 18, cette diode étant encadrée par 2 diodes Schottky 33/1, 33/2 polarisées en inverse et correspondant aux contacts couche métallique 22 couche-semiconductrice 16 situés de part et d'autre du mésa. La polarisation inverse de ces deux diodes est égale à la chute de tension provoquée dans la résistance 32. Cette chute est de l'ordre de 0,5 V pour un contact Au-Zn et pour un courant de seuil de 0,25 A et une résistance série de l'ordre de 2 Ω. Cette chute est nettement plus faible que la tension de claquage de la diode Schottky, qui est de l'ordre de quelques volts. Les deux contacts latéraux Ti-Au créent donc un isolement électrique très efficace.

L'article de M.C. AMANN intitulé »New stripe geometry laser with simplified fabrication process« publié dans la revue »Electronics Letters« 5 juillet 79, Vol. 15 N° 14, p. 441, décrit un laser à ruban valable pour les lasers Ga As—Ga Al As qui peut rappeler à certains égards, celui qui vient d'être décrit, car il contient lui aussi une couche métallique (Cr-Au) recouvrant l'ensemble de la structure. En réalité, la structure de l'invention est fondamentalement différente, tout au moins en ce qui concerne cette question de confinement de l'injection des charges. En effet, la structure antérieure est basée sur la différence de résistance entre les contacts de la couche Cr-Au pris soit sur Ga As, soit sur Ga Al As, mais en aucun cas sur la création d'un contact Schottky. L'application de la structure de l'art antérieur au cas des doubles hétérostructures In Ga As P/In P ne conviendrait pas car la différence de résistance de contact qui serait obtenue dans ce cas serait insuffisante. L'alliage du contact aurait pour effet de créer une région surdopée en zinc à la fois sur la couche de contact et la couche de confinement et provoquerait ainsi des résistances de contact de valeurs insufisamment différentes.

En ce qui concerne le procédé de réalisation du laser décrit, il faut noter que la difficulté majeure réside dans la définition du mésa et la prise de contact alliée Au-Zn sur le dessus. L'ordre des opérations qui est choisi dans l'invention parce qu'il convient le mieux est le suivant:

- définition du mésa par attaque chimique à l'aide d'un masque de résine,
- dépôt du contact Au-Zn par la technique dite »lift off« qui consiste à retirer un film de résine situé sous le métal et à entraîner ce dernier avec la résine,
- recuit du contact pour former l'alliage.

L'ordre inverse qui consisterait à faire d'abord le contact Au-Zn et à se servir de ce contact comme masque pour l'attaque chimique de la couche de contact, conduirait à une très mauvaise définition géométrique du ruban du fait d'une sous gravure importante sous le contact.

A titre explicatif, les différentes opérations du procédé de fabrication peuvent être les suivantes:

1) Amincissement de la plaque épitaxiée, côté substrat selon un procédé utilisé pour les lasers As-Ga de façon à obtenir des clivages de bonne qualité.
2) Réalisation des contacts:
   2-1 Côté substrat (n):
   Dépôt par évaporation sous vide d'une couche de Au-Ge de 1000 Å environ sur une sous couche de quelques centaines d'Å de Ni favorisant l'adhérence de Au-Ge, (1 Å = $10^{-10}$ m)
   2-2 Côté couches (p):
   Protection de la couche de contact In Ga As localement par un ruban de résine de largeur typiquement 20 $\mu m$ et attaque chimique de façon à dégager la couche de confinement In P par une solution $SO_4H_2 + H_2O_2 + H_2O$ dans les proportions 3/1/3 à température ambiante. En effet, bien que sélective, cette solution pourrait attaquer In Ga As et aurait tendance, si l'attaque était trop violente, à faire une sous gravure sans le ruban de résine. A 20°C la vitesse d'attaque est environ lµ/mn et la largeur des rubans reste bien définie. Après obtention du mésa, superposition par la technique dite de »lift off«, du ruban en Au-Zn (5%) par évaporation sous vide d'épaisseur environ 2000 Å.

2-3 Recuit des contacts ohmiques:

Les contacts Au-Ge-Ni et Au-Zn sont recuits en même temps vers 440°C dans un four sous atmosphère d'argon hydrogéné, le refroidissement étant amorcé dès que la température de 440°C est atteinte. Dans ces conditions, une résistance de contact de $3 \cdot 10^{-5}\ \Omega cm^2$ est obtenue sur le côté n et de $1{,}25\ 10^{-4}$ sur $In_{0,53}\,Ga_{0,47}\,As$.

2-4 Contacts Schottky:

Dépôt d'une couche de Ti-Au (200 Å bis 3000 Å), le titane ayant, comme le nickel, pour but d'améliorer l'adhérence de l'or sur la couche de In P.

Les lasers réalisés de cette manière fonctionnent en continu à température ambiante avec des courants de seuil plus faibles que ceux que l'on obtient par les techniques antérieures. Des lasers continus à 130 mA de courant de seuil ont été obtenus pour des rubans de 20 µm de large, de 180 µm de long et d'épaisseur de région active 0,4 µm. En réduisant l'épaisseur de la couche active à 0,2 µm ainsi que la largeur du ruban à environ 12 µm (largeur optimale des lasers Ga Al As) un courant de seuil de 50 mA peut être atteint ce qui est nettement mieux que dans le cas des techniques antérieures (à l'exception des lasers à canal enterré mais pour lesquels cependant on se heurte à des difficultés sérieuses de réalisation, évoquées plus haut).

Les lasers conformes à l'invention sont, en outre, monomodes transverse; la largeur typique du diagramme de rayonnement à mi-hauteur est de 7° dans le plan parallèle à la jonction et 40° dans le plan perpendiculaire.

## Revendications

1. Source lumineuse laser du type à double hétérostructure et à jonction en ruban, comprenant un substrat (10) sur lequel sont déposées successivement, une couche inférieure de confinement (12) en un premier matériau semiconducteur de type n, une couche active (14) en un second matériau semiconducteur, une couche supérieure de confinement (16) en In P de type p faiblement dopé, une couche de contact (18) en un quatrième matériau semiconducteur de type p fortement dopé, une couche métallique alliée (20), cette couche de contact (18) et la couche métallique alliée (20) ayant une forme de mésa, une couche métallique (22, 24) recouvrant le mésa et la couche supérieure de confinement, cette couche métallique (22, 24) formant un contact ohmique avec le matériau semiconducteur et la couche métallique alliée (20) formant le mésa et un contact SCHOTTKY avec la couche supérieure de confinement (16), dans les deux zones latérales encadrant le contact ohmique.

2. Source lumineuse selon la revendication 1, caractérisée par le fait que la couche métallique alliée (20) est un dépôt allié Au-Zn.

3. Source lumineuse selon l'une quelconque des revendications 1 et 2, caractérisée par le fait que la couche métallique est un film de titane (22) revêtu d'un dépôt d'or.

4. Source lumineuse selon l'une quelconque des revendications 1 à 3, caractérisée par le fait que le premier matériau semiconducteur formant la couche inférieure de confinement est en InP.

5. Source lumineuse selon l'une quelconque des revendications 1 à 4, caractérisée par le fait que la couche active est en $Ga_x\text{-}In_{1-x}As_yP_{1-y}$ (x et y étant des nombres inférieurs à 1).

6. Source lumineuse selon l'une quelconque des revendications 1 à 5, caractérisée par le fait que le matériau constituant la couche de contact (18) a pour composition $Ga_xIn_{1-x}As$ (x inférieur à 1).

7. Source lumineuse selon l'une quelconque des revendications 1 à 6, caractérisée par le fait que le dopage de la couche supérieure de confinement en InP est de l'ordre de $10^{16}$ $cm^{-3}$.

8. Procédé de réalisation d'une source lumineuse selon la revendication 7, dans lequel on réalise la double hétérostructure par dépôts successifs de couches semiconductrices par épitaxie en phase liquide sur un substrat monocristallin, caractérisé en ce qu'on donne à la couche de contact une forme de mésa par décapage chimique sélectif des parties latérales de cette couche, puis en ce qu'on procède au dépôt d'un contact métallique allié sur la partie supérieure du mésa et en ce qu'on recouvre enfin l'ensemble d'une couche métallique.

9. Procédé selon la revendication 8, caractérisé par le fait que le décapage chimique est effectué à l'aide d'une solution $SO_4H_2 + H_2O_2 + H_2O$.

## Patentansprüche

1. Laserquelle mit doppelter Heterostruktur und bandförmigem Übergang, bestehend aus einem Substrat (10), auf dem aufeinanderfolgend niedergeschlagen sind: eine untere Begrenzungsschicht (12) und eine n-leitende erste Halbleiterschicht, eine aktive Schicht (14) aus einem zweiten Halbleitermaterial, eine obere Begrenzungsschicht (16) aus schwach dotiertem, p-leitendem InP, eine Kontaktschicht (18) aus einem vierten, stark dotierten p-leitendem Halbleitermaterial, eine legierte Metallschicht (20), wobei die Kontaktschicht (18) und die legierte Metallschicht (20) einen erhöhten Absatz bilden, eine den erhöhten Absatz und die obere Begrenzungsschicht (16) bedeckende Metallschicht (22, 24), die einen ohmschen Kontakt mit dem Halbleitermaterial und der legierten Metallschicht (20), die den erhöhten Absatz bilden, herstellt, und einen Schottky-Übergang mit der oberen Begrenzungsschicht (16) in den zwei Seitenzonen, die den ohmschen Kontakt einrahmen, herstellt.

2. Laserquelle nach Anspruch 1, dadurch gekennzeichnet, daß die legierte Metallschicht (20) ein legierter Niederschlag aus Au-Zn ist.

3. Laserquelle nach einem der Ansprüche 1 und 2, dadurch gekennzeichnet, daß die Metallschicht aus einem Titanfilm (22) besteht.

4. Laserquelle nach einem der Ansprüche 1 bis 3, dadurch gekennzeichnet, daß das erste halbleitende Material, das die untere Begrenzungsschicht bildet, InP ist.

5. Laserquelle nach einem der Ansprüche 1 bis 4, dadurch gekennzeichnet, daß die aktive Schicht aus $Ga_x$-$In_{1-x}As_yP_{a-y}$ besteht (x und y sind Zahlen kleiner 1).

6. Laserquelle nach einem der Ansprüche 1 bis 5, dadurch gekennzeichnet, daß das Material, das die Kontaktschicht (18) bildet, als Zusammensetzung $Ga_xIn_{1-x}As$ (mit x kleiner als 1) enthält.

7. Laserquelle nach einem der Ansprüche 1 bis 6, dadurch gekennzeichnet, daß die Dotierung der oberen Begrenzungsschicht mit InP in der Größenordnung von $10^{16}$ $cm^{-3}$ beträgt.

8. Verfahren zur Herstellung einer Laserquelle nach Anspruch 7, wobei man die doppelte Heterostruktur durch aufeinanderfolgenden Niederschlag von halbleitenden Schichten in Epitaxie in flüssiger Phase auf einem monokristallinen Substrat erzielt, dadurch gekennzeichnet, daß man der Kontaktschicht die Form eines erhöhten Absatzes gibt, indem man durch chemisches Abtragen selektiv die seitlichen Bereiche dieser Schicht entfernt und dann auf den erhöhten Absatz einen legierten metallischen Kontakt niederschlägt und die Anordnung dann mit einer Metallschicht bedeckt.

9. Verfahren nach Anspruch 8, dadurch gekennzeichnet, daß das chemische Abtragen mit Hilfe einer Lösung aus $H_2SO_4+H_2O_2+H_2O$ durchgeführt wird.

## Claims

1. Laser source of the double heterostructure, ribbon-junction type, comprising a substrate (10) on which are successively deposited, a lower confinement layer (12) of a first, n-type, semiconductor material, an active layer (14) of a second semiconductor material, an upper confinement layer (16) of p-type, lightly-doped InP, a contact layer (18) of a fourth, highly doped p-type semiconductor material, a metal alloy layer (20), said contact layer (18) and metal alloy layer (20) being in the form of a mesa, and a metal layer (22, 24) covering the mesa and the upper confinement layer, said metal layer (22, 24) being in ohmic contact with the semiconductor material and the metal alloy layer (20) forming the mesa, and in SCHOTTKY contact with the upper confinement layer (16) in the two side zones bordering the ohmic contact.

2. Laser source according to claim 1, characterized in that the metal alloy layer (20) is a deposit of An-Zn alloy.

3. Laser source according to either of claims 1 and 2, characterized in that the metal layer is a film of titanium (22) covered with a gold deposit.

4. Laser source according to any of claims 1 to 3, characterized in that the first semiconductor material forming the lower confinement layer comprises InP.

5. Laser source according to any of claims 1 to 4, characterized in that the active layer comprises $Ga_x$-$In_{1-x}As_yP_{1-y}$ (wherein x and y are numbers less than 1).

6. Laser source according to any of claims 1 to 5, characterized in that the material constituting the contact layer (18) has the composition $Ga_x$-$In_{1-x}As$ (wherein x is less than 1).

7. Laser source according to any of claims 1 to 6, characterized in that the doping of the upper confinement layer comprising InP is of the order of $10^{16}$ $cm^{-3}$.

8. Process for the formation of a laser source according to claim 7 in which the double heterostructure is produced by successively depositing the semiconductor layers by epitaxial growth in liquid phase on a monocrystalline substrate, characterized in that the contact layer is given the form of a mesa by selective chemical etching of the side portions of said layer, in that a metal alloy contact is then deposited on the upper part of the mesa, and in that the assembly is then covered with a metal layer.

9. Process according to claim 8, characterized in that the chemical etching is effected by means of an $H_2SO_4$-$H_2O_2$-$H_2O$ solution.

FIG.1

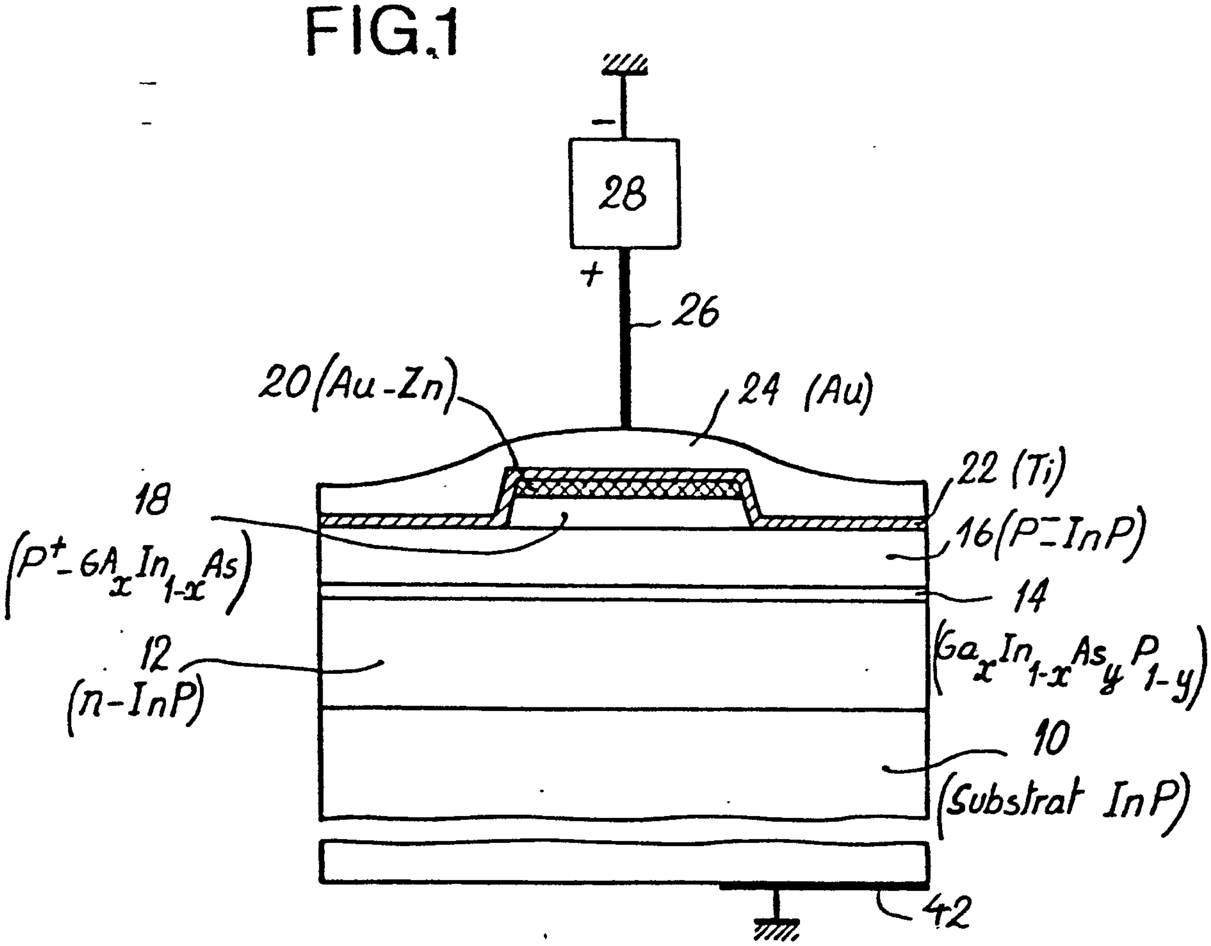
28
26
20 (Au-Zn)
24 (Au)
22 (Ti)
18
(P+- GAxIn1-xAs)
16 (P--InP)
14
(GaxIn1-xAsyP1-y)
12
(n-InP)
10
(Substrat InP)
42

FIG.2

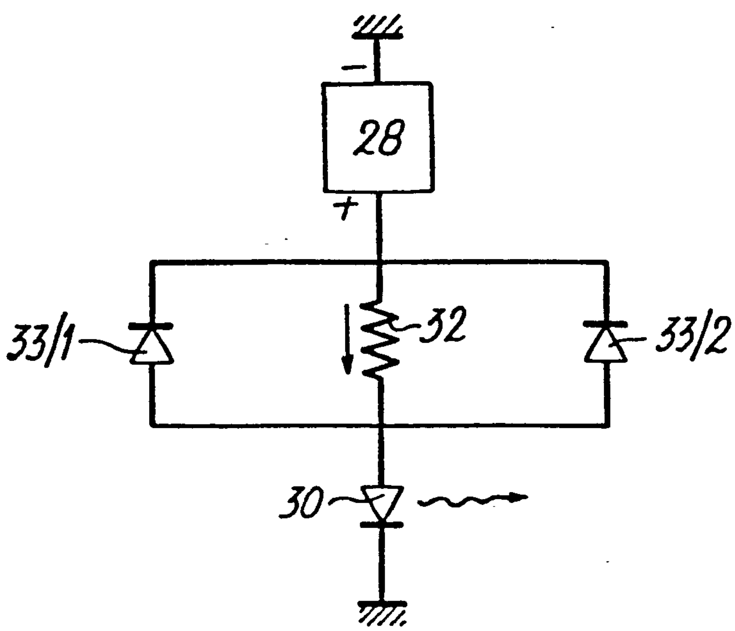
28
33/1
32
33/2
30